# EUROPÄISCHE PATENTANMELDUNG

(11) **EP 3 439 028 A1**
(43) Veröffentlichungstag der Anmeldung: **06.02.2019**
(21) Anmeldenummer: 17184760.1
(22) Anmeldetag: 03.08.2017
(51) Int. Cl.: H01L 23/00, H01L 23/13, H01L 25/07

(54) **LEISTUNGSMODUL MIT MINDESTENS EINEM LEISTUNGSHALBLEITER**

(71) Anmelder: Siemens Aktiengesellschaft, 80333 München (DE)
(72) Erfinder: Pfefferlein, Stefan, 90562 Heroldsberg (DE)

(57) **Zusammenfassung**

Die Erfindung betrifft ein Leistungsmodul (2) mit mindestens einem Leistungshalbleiter (4), insbesondere einem Leistungstransistor, welcher eine erste Kontaktfläche (4a) und eine der ersten Kontaktfläche (4a) gegenüberliegende zweite Kontaktfläche (4b) aufweist, und einem Substrat (6), welches zumindest zwei übereinander angeordnete miteinander verbundene Lagen (8, 10) umfasst. Um eine, im Vergleich zum Stand der Technik, höhere Beständigkeit gegenüber Feuchtigkeit zu erreichen und eine niederinduktive planare Anbindung des mindestens einen Leistungshalbleiters (4) zu ermöglichen, wird vorgeschlagen, dass die erste Lage (8) ein erstes dielektrisches Material (12) mit zumindest einer ersten Metallisierung (14) umfasst, wobei die erste Metallisierung (14) auf einer der der zweiten Lage (10) zugewandten Seite angeordnet ist, wobei die zweite Lage (10) ein zweites dielektrisches Material (14) mit zumindest einer zweiten Metallisierung (16) umfasst, wobei die zweite Metallisierung (16) auf einer der ersten Metallisierung (14) abgewandten Seite angeordnet ist, wobei der Leistungshalbleiter (4) über die erste Kontaktfläche (4a) mit der ersten Metallisierung (14) verbunden ist, wobei der Leistungshalbleiter (4) in einer ersten Aussparung (20) der zweiten Lage (10) angeordnet ist, wobei eine metallische erste Kapselung (28) derartig angeordnet ist, dass der Leistungshalbleiter (4) fluiddicht gekapselt ist und die zweite Kontaktfläche (4b) des Leistungshalbleiters (4) über die erste Kapselung (28) elektrisch leitend mit der zweiten Metallisierung (16) verbunden ist.

## Beschreibung

Die Erfindung betrifft ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst.

Darüber hinaus betrifft die Erfindung ein Verfahren zur Herstellung eines derartigen Leistungsmoduls.

Ein derartiges Leistungsmodul mit Leistungshalbleitern wird beispielsweise in einem Stromrichter eingesetzt. Herkömmliche Leistungsmodule sind aufgrund ihres Aufbaus anfällig für das Eindringen von Feuchtigkeit. Durch die eindringende Feuchtigkeit kommt es, insbesondere im Betrieb, beispielsweise im Bereich von Feldringen der Leistungshalbleiter zu Korrosionserscheinungen und folglich zu einem frühzeitigen Ausfall.

Eine Behebung der Anfälligkeit für Feuchtigkeit auf Leistungshalbleiterebene und/oder eine Verwendung von Leistungshalbleitern mit weniger feuchtigkeitsanfälligem Packaging sind mit erheblichen Einschränkungen in der Verfügbarkeit passender Leistungshalbleiter verbunden.

Eine Kapselung mit organischen Vergussmaterialien, wie beispielsweise Polymeren, ist anfällig gegen weitere Umwelteinflüsse, wie beispielsweise Strahlung oder aggressive Stoffe, die das Vergussmaterial beschädigen oder gar zersetzen.

Zusätzlich ist eine niederinduktive Anbindung der Leistungshalbleiter erforderlich, um eine ausreichend schnelle Schaltgeschwindigkeit der Leistungshalbleiter und damit einen hohen Wirkungsgrad zu ermöglichen. Insbesondere Bonddrähte sind verantwortlich für parasitäre Induktivitäten, welche Überspannungen verursachen und Schaltverluste erhöhen.

Die Offenlegungsschrift DE 10 2013 112 029 A1 beschreibt ein Halbleiterbauelement mit einer Kapselung, die anorganische Partikel, beispielsweise Glas, umfasst.

Die Offenlegungsschrift EP 1 255 299 A2 beschreibt ein Leistungshalbleitermodul bestehend aus einem Gehäuse, einem keramischen Substrat, schaltungsgerecht darauf angeordneten strukturierten und elektrisch leitenden Kontaktflächen, darauf angeordneten Bauelementen, einer Druckkontaktierung bestehend aus einem flexiblen Druckspeicher sowie einer den Druck erzeugenden Druckplatte, sowie Leistungs- und Steueranschlüsse. Bei der Erhöhung der Leistungsfähigkeit, der Zuverlässigkeit sowie der Lebensdauer bei gleichzeitig verringerten Herstellungskosten sind veränderte Methoden der Aufbautechnologien für die einzelnen Bestandteile eine zwingende Voraussetzung. Dies wird erreicht durch eine flexible Leiterplatte, die die Bauelemente schaltungsgerecht miteinander und/oder mit den Kontaktflächen des Substrates verbindet, wobei zur Isolation der Bauelemente gegeneinander ein flexibler Isolationsstoff eingebracht ist.

Der Erfindung liegt die Aufgabe zugrunde, ein Leistungsmodul mit mindestens einem Leistungshalbleiter anzugeben, das eine, im Vergleich zum Stand der Technik, höhere Beständigkeit gegenüber Feuchtigkeit bietet und eine niederinduktive planare Anbindung des mindestens einen Leistungshalbleiters ermöglicht.

Diese Aufgabe wird erfindungsgemäß durch ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst, gelöst, wobei die erste Lage ein erstes dielektrisches Material mit zumindest einer ersten Metallisierung umfasst, wobei die erste Metallisierung auf einer der zweiten Lage zugewandten Seite angeordnet ist, wobei die zweite Lage ein zweites dielektrisches Material mit zumindest einer zweiten Metallisierung umfasst, wobei die zweite Metallisierung auf einer der ersten Metallisierung abgewandten Seite angeordnet ist, wobei der Leistungshalbleiter über die erste Kontaktfläche mit der ersten Metallisierung verbunden ist, wobei der Leistungshalbleiter in einer ersten Aussparung der zweiten Lage angeordnet ist, wobei eine metallische erste Kapselung derartig angeordnet ist, dass der Leistungshalbleiter fluiddicht gekapselt ist und die zweite Kontaktfläche des Leistungshalbleiters über die erste Kapselung elektrisch leitend mit der zweiten Metallisierung verbunden ist.

Ferner wird diese Aufgabe erfindungsgemäß durch ein Verfahren zur Herstellung eines derartigen Leistungsmoduls gelöst, wobei die erste Kontaktfläche des Leistungshalbleiters elektrisch leitend mit der ersten Metallisierung der ersten Lage verbunden wird, daraufhin die zweiten Lage, welche eine erste Aussparung um den Leistungshalbleiter herum aufweist, mit der ersten Lage verbunden wird, daraufhin eine metallische erste Kapselung derartig angeordnet wird, dass der Leistungshalbleiter fluiddicht gekapselt wird und die zweite Kontaktfläche des Leistungshalbleiters über die erste Kapselung elektrisch leitend mit der zweiten Metallisierung verbunden wird.

Die in Bezug auf das Leistungsmodul nachstehend angeführten Vorteile und bevorzugten Ausgestaltungen lassen sich sinngemäß auf das Herstellungsverfahren übertragen.

Der Erfindung liegt die Überlegung zugrunde, die Leistungshalbleiter in einem Leistungsmodul anorganisch zu kapseln, um eine verbesserte Beständigkeit gegenüber Feuchtigkeit und anderen Umwelteinflüssen zu erreichen. Ferner sollen die Leistungshalbleiter über eine erste Kontaktfläche und eine der ersten Kontaktfläche gegenüberliegenden zweiten Kontaktfläche niederinduktiv an ein Substrat angebunden werden, um einen hohen Wirkungsgrad zu erreichen. Das Substrat weist zumindest zwei Lagen auf, welche insbesondere stoffschlüssig miteinander verbunden sind, wobei eine Lage Aussparungen aufweist, in die jeweils zumindest ein Leistungshalbleiter eingesetzt ist. Durch eine insbesondere stoffschlüssige Verbindung der Lagen, die den Leistungshalbleiter insbesondere ringförmig umgibt, entsteht ein Vergussraum, der in eine Richtung über die Aussparungen geöffnet ist. Beispielsweise sind die Lagen als Direct-Copper-Bonding Substrat, kurz DCB-Substrat, ausgeführt, das eine Keramikplatte aufweist, auf welcher eine Metallisierung, insbesondere eine Kupfermetallisierung, mit sehr hoher Haftfestigkeit auflaminiert ist. Die Leistungshalbleiter, beispielsweise Transistoren oder Dioden, werden insbesondere geflippt und mit der ersten Kontaktfläche, der eigentlichen Chipoberseite, auf dem DCB-Substrat bestückt, wobei die Leistungshalbleiter auf die Metallisierung der Lage gesintert oder gelötet werden. Eine derartige Verbindung weist eine signifikant geringere parasitäre Induktivität als eine Bonddrahtverbindung auf und ist daher verlustärmer. Eine elektrische Kontaktierung der zweiten Kontaktfläche, der eigentlichen Chipunterseite, erfolgt über eine erste Kapselung, welche insbesondere als Metallabscheidung ausgeführt ist und zumindest über dem Leistungshalbleiter und der, insbesondere umgebenden, Metallisierung verläuft. Insbesondere ist die Kapselung stoffschlüssig mit der Metallisierung verbunden, sodass der jeweilige Leistungshalbleiter durch die erste Kapselung über der Aussparung fluiddicht gekapselt ist. Darüber hinaus ist die zweite Kontaktfläche des Leistungshalbleiters über die erste Kapselung niederinduktiv und damit verlustarm elektrisch kontaktiert.

In einer bevorzugten Ausgestaltung ist die erste Kapselung über ein additives Fertigungsverfahren hergestellt. Insbesondere wird die erste Kapselung über eine additive Metallabscheidung, beispielsweise durch thermisches Metallspritzen, direkt lokal aufgebracht. Die erste Kapselung wird beispielsweise aus Kupfer, Silber, Zinn und/oder Aluminium hergestellt und wird mit Hilfe des additiven Fertigungsverfahrens fluiddicht verbunden, wodurch eine hohe Beständigkeit gegenüber Flüssigkeiten und Luftfeuchtigkeit erreicht wird. Das additive Fertigungsverfahren bietet eine große Flexibilität hinsichtlich der Form, der Dicke und des Materials der Kapselung. Ferner ist die Kapselung nach dem Bestücken, insbesondere im Vergleich zu individuell angepassten und aufgelöteten Deckeln aus Metallblechen, leicht und kostengünstig herzustellen.

In einer weiteren vorteilhaften Ausführungsform ist in der ersten Aussparung ein elektrisch isolierendes Vergussmaterial angeordnet. Das Vergussmaterial weist insbesondere einen elastischen temperaturbeständigen Kunststoff, beispielsweise Underfill, auf, damit der Aufbau durch unterschiedliche thermische Ausdehnungskoeffizienten des Leistungshalbleiters und des Substrats nicht zerstört wird. Beispielsweise wird ein epoxidbasierter Kunststoff verwendet, um gute Isolationseigenschaften zu erreichen.

Besonders vorteilhaft umfasst die erste Lage eine dritte Metallisierung, welche auf einer der ersten Metallisierung gegenüberliegenden Seite angeordnet ist und/oder umfasst die zweite Lage eine vierte Metallisierung, welche auf einer der zweiten Metallisierung gegenüberliegenden Seite angeordnet ist. Insbesondere ist mindestens eine der Lagen als DCB-Substrat ausgeführt. Durch die größere Anzahl von Metallisierungen verkürzen sich die Zuleitungslängen, was zu einer Reduzierung der parasitären Induktivitäten und einer Verringerung der Leitungsverluste führt. Ferner verkleinert sich die benötigte Fläche des Substrats.

In einer weiteren vorteilhaften Ausgestaltung ist die erste Kapselung stoffschlüssig mit der zweiten Kontaktfläche des Leistungshalbleiters verbunden. Insbesondere wird die stoffschlüssige Verbindung mittelbar über einen Löt- und/oder Sinterwerkstoff hergestellt. Alternativ ist die erste Kapselung unmittelbar stoffschlüssig mit der zweiten Kontaktfläche des Leistungshalbleiters verbunden. Durch eine derartige stoffschlüssige Verbindung werden parasitäre Effekte, insbesondere bei der elektrischen Kontaktierung, erheblich reduziert. Ferner wird die thermische Anbindung an das Substrat verbessert, sodass eine optimale Entwärmung des Leistungshalbleiters stattfindet. Insbesondere schützt eine vor der Kapselung auf der zweiten Kontaktfläche des Leistungshalbleiters aufgebrachte Schicht aus einem Löt- und/oder Sinterwerkstoff den Chip vor einer kinetischen Aufprallenergie, welche beispielsweise bei einem additiven Metallauftragen der ersten Kapselung entsteht.

In einer bevorzugten Ausgestaltung weist die zweite Metallisierung eine umlaufende Metallisierung auf, welche um die erste Aussparung der zweiten Lage angeordnet ist, wobei die erste Kapselung fluiddicht mit der umlaufenden Metallisierung verbunden ist. Durch die umlaufende Metallisierung werden eine optimale elektrische und thermische Kontaktierung der Kapselung und eine maximale Reduzierung der parasitären Induktivität erreicht. Ferner wird die Aussparung durch die Kapselung optimal abgedichtet.

Besonders vorteilhaft erstreckt sich die erste Kapselung zumindest über die erste Aussparung und zumindest über einen Teil der umlaufenden Metallisierung. Durch eine Überlappung der Kapselung mit zumindest einem Teil der umlaufenden Metallisierung werden Fertigungstoleranzen ausgeglichen.

In einer weiteren vorteilhaften Ausgestaltung ist zumindest ein Teil der ersten Metallisierung über eine zweite Kapselung mit zumindest einem Teil der zweiten Metallisierung elektrisch leitend verbunden. Die zweite Kapselung wird insbesondere aus Kupfer, Silber, Zinn und/oder Aluminium hergestellt. Beispielsweise wird durch eine derartige Verbindung zwischen den beiden Lagen eine Gateübergabe hergestellt. Eine derartige Verbindung ist verlustarm sowie leicht und kostengünstig herzustellen.

In einer bevorzugten Ausgestaltung ist in der zweiten Aussparung ein elektrisch isolierendes Vergussmaterial angeordnet und die zweite Aussparung ist durch die zweite Kapselung fluiddicht verschlossen. Durch das elektrisch isolierende Vergussmaterial werden Kurzschlüsse und Überkopplungen verhindert. Durch eine fluiddichte Kapselung wird insbesondere verhindert, dass Feuchtigkeit, beispielsweise über eine Gateübergabe, zum Leistungshalbleiter vordringt.

Besonders vorteilhaft ist die zweite Kapselung über ein, insbesondere als Ronde ausgeführtes, metallisches Formteil mit der ersten Metallisierung verbunden. Eine derartige Ronde wird beispielsweise aus Kupfer oder einem Sinterwerkstoff, insbesondere Sinterpaste, hergestellt. Das metallische Formteil ermöglicht durch seinen geringen Widerstand und seine geringe Induktivität eine verlustarme Verbindung, welche leicht und kostengünstig herzustellen ist.

In einer bevorzugten Ausgestaltung ist die zweite Kapselung über ein additives Fertigungsverfahren hergestellt. Insbesondere wird die zweite Kapselung ebenfalls über eine additive Metallabscheidung, beispielsweise durch thermisches Metallspritzen, direkt lokal aufgebracht. Das additive Fertigungsverfahren bietet eine große Flexibilität hinsichtlich der Form, der Dicke und des Materials der Kapselung. Ferner ist die Kapselung nach dem Bestücken, insbesondere im Vergleich zu individuell angepassten und aufgelöteten Deckeln aus Metallblechen, leicht und kostengünstig herzustellen.

Im Folgenden wird die Erfindung anhand der in den Figuren dargestellten Ausführungsbeispiele näher beschrieben und erläutert.

Es zeigen:
- FIG 1: einen Querschnitt einer ersten Ausführungsform eines Leistungsmoduls im Bereich eines Leistungshalbleiters,
- FIG 2: einen Querschnitt einer zweiten Ausführungsform eines Leistungsmoduls im Bereich eines Leistungshalbleiters,
- FIG 3: einen Querschnitt einer dritten Ausführungsform eines Leistungsmoduls im Bereich einer Verbindung zwischen zwei Lagen,
- FIG 4: einen Querschnitt einer vierten Ausführungsform eines Leistungsmoduls im Bereich eines Leistungshalbleiters,
- FIG 5: verschiedene Verfahrensschritte a) bis f) zur Herstellung der vierten Ausführungsform des Leistungs-moduls,
- FIG 6: einen Querschnitt der vierten Ausführungsform des Leistungsmoduls mit einer ersten Ausführungsform einer Kontaktierung an eine Leiterplatte,
- FIG 7: einen Querschnitt der vierten Ausführungsform des Leistungsmoduls mit einer zweiten Ausführungsform einer Kontaktierung an eine Leiterplatte und
- FIG 8: einen Querschnitt der vierten Ausführungsform des Leistungsmoduls mit einer dritten Ausführungsform einer Kontaktierung an eine Leiterplatte.

Gleiche Bezugszeichen haben in den verschiedenen Figuren die gleiche Bedeutung.

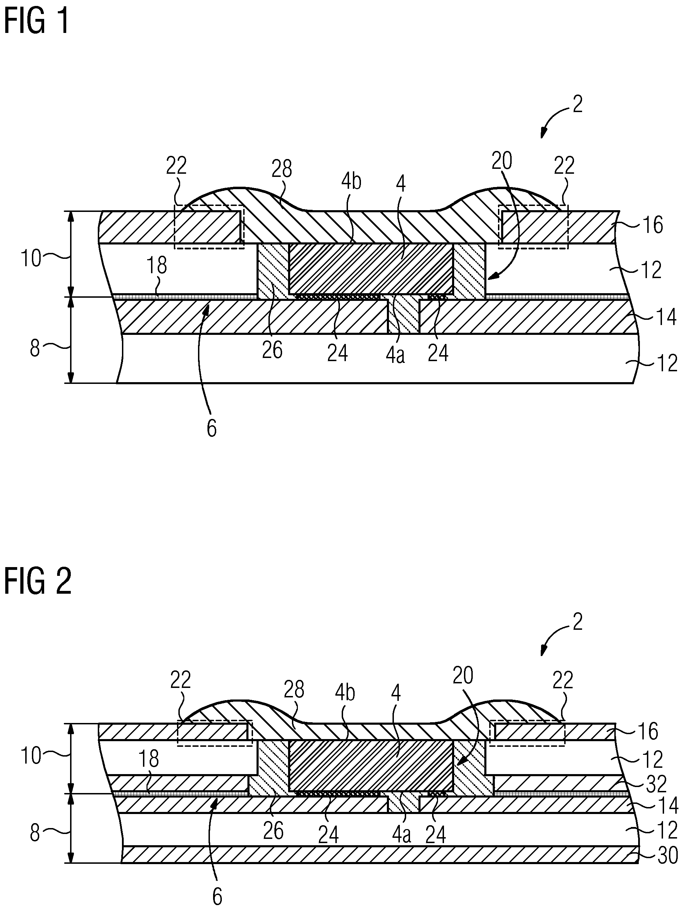

FIG 1 zeigt einen Querschnitt einer ersten Ausführungsform eines Leistungsmoduls 2 im Bereich eines Leistungshalbleiters 4, welcher als Leistungstransistor, insbesondere als Feldeffekttransistor oder als IGBT, ausgeführt ist. Der Leistungshalbleiter 4 kann alternativ auch als Diode ausgeführt sein und ist auf einem Substrat 6 angeordnet. Das Substrat 6 umfasst eine erste Lage 8 und eine auf der ersten Lage 8 angeordnete zweite Lage 10. Die Lagen 8, 10 umfassen jeweils ein als eine Keramikplatte ausgeführtes dielektrisches Material 12, wobei die Keramikplatte beispielsweise aus Aluminiumoxid und/oder Aluminiumnitrid mit einer Dicke von 250 µm bis 1 mm hergestellt ist. Die erste Lage 8 umfasst eine mit der Keramikplatte verbundene erste Metallisierung 14. Die zweite Lage 10 umfasst eine zweite Metallisierung 16, welche auf einer der ersten Metallisierung 14 abgewandten Seite angeordnet ist. Die beiden Lagen 8, 10 sind über eine, insbesondere adhäsive, Verbindung 18 flächig, insbesondere vollflächig, miteinander verbunden. Die Metallisierungen 14, 16 werden beispielsweise aus Kupfer mit einer Dicke zwischen 150 µm und 750 µm hergestellt und sind derartig strukturiert, dass beispielsweise metallische Leiterbahnen auf dem dielektrischen Material 12 ausgebildet sind.

Die zweite Lage 12 weist eine erste Aussparung 20 auf, welche auch Kavität genannt wird und in welcher der Leistungshalbleiter 4 angeordnet ist. Die zweite Metallisierung 16 der zweiten Lage 12 bildet um den Rand der ersten Aussparung 20 eine umlaufende Metallisierung 22 aus. Der Leistungshalbleiter 4 weist eine erste Kontaktfläche 4a und eine der ersten Kontaktfläche 4a gegenüberliegende zweite Kontaktfläche 4b auf. Der Leistungshalbleiter 4 ist geflippt mit seiner ersten Kontaktfläche 4a über eine stoffschlüssige Verbindung 24 mit der ersten Metallisierung 14 verbunden. Insbesondere wird die stoffschlüssige Verbindung 24 über Löten oder Sintern hergestellt.

Die erste Aussparung 20 mit dem Leistungshalbleiter 4 ist mit einem elektrisch isolierenden Vergussmaterial 26 aufgefüllt. Das Vergussmaterial 26 umfasst einen elastischen temperaturbeständigen Kunststoff, beispielsweise Underfill, damit der Aufbau durch unterschiedliche thermische Ausdehnungskoeffizienten des Leistungshalbleiters 4 und des Substrats 6 nicht zerstört wird. Beispielsweise wird epoxidbasierter Kunststoff verwendet, um gute Isolationseigenschaften zu erreichen. Das Vergussmaterial 26 verläuft oberhalb der ersten Metallisierung 14 und maximal bis zur zweiten Kontaktfläche 4b des Leistungshalbleiters 4. Darüber hinaus ist die erste Aussparung 20 mit einer metallischen ersten Kapselung 28 derartig verschlossen, dass der Leistungshalbleiter 4 fluiddicht gekapselt ist und die zweite Kontaktfläche 4b des Leistungshalbleiters 4 über die erste Kapselung 28 elektrisch leitend mit der zweiten Metallisierung 16 der zweiten Lage 12 des Substrats 8 verbunden ist. Die erste Kapselung 28 ist als Metallabscheidung aus Kupfer, Silber, Zinn und/oder Aluminium ausgeführt.

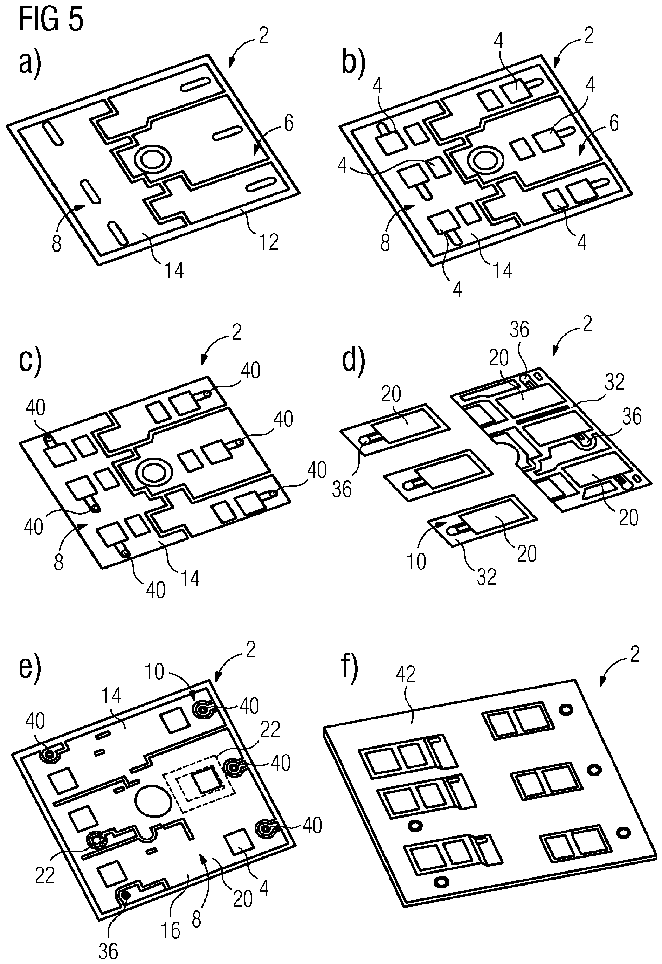

Die erste Kapselung 28 wird über ein additives Fertigungsverfahren hergestellt. Insbesondere wird die erste Kapselung 28 über additive Metallabscheidung, beispielsweise durch thermisches Metallspritzen, direkt lokal aufgebracht, sodass die erste Kapselung 28 unmittelbar nach der Herstellung fluiddicht mit der umlaufenden Metallisierung 22 verbunden ist und die erste Kapselung 28 stoffschlüssig mit der zweiten Kontaktfläche 4b des Leistungshalbleiters 4 verbunden ist. Beispielswiese werden die nicht zu metallisierenden Bereiche der Oberfläche des Substrats 8 vor dem Aufbringen der ersten Kapselung 28 während der Fertigung durch eine Schablone 42 abgedeckt. Die Schablone 42, welche in FIG 5 dargestellt ist, bietet den Vorteil einer präzisen und dabei schnellen Fertigung. Alternativ zur additiven Metallabscheidung wird die erste Kapselung 28 nach der Herstellung mit der umlaufenden Metallisierung 22, insbesondere durch Löten, fluiddicht verbunden.

FIG 2 zeigt einen Querschnitt einer zweiten Ausführungsform eines Leistungsmoduls 2 im Bereich eines Leistungshalbleiters 4. Die Lagen 8, 10 des Substrats 6 sind jeweils als Direct-Copper-Bonding Substrat, kurz DCB-Substrat, ausgeführt und umfassen jeweils ein als eine Keramikplatte ausgeführtes dielektrisches Material 12. Die erste Lage 8 umfasst eine, mit der Keramikplatte verbundene, erste Metallisierung 14 und eine, auf einer gegenüberliegenden Seite mit der Keramikplatte verbundene, dritte Metallisierung 30. Die zweite Lage 10 umfasst eine, mit der Keramikplatte verbundene, zweite Metallisierung 16 und eine, auf einer gegenüberliegenden Seite mit der Keramikplatte verbundene, vierte Metallisierung 32. Die erste Metallisierung 14 der ersten Lage 8 ist flächig und elektrisch leitfähig mit der vierten Metallisierung 32 der zweiten Lage 10 verbunden. Insbesondere wird die Verbindung 18 der Lagen 8, 10 durch Löten oder Sintern hergestellt. Die Metallisierungen 14, 16, 30, 32 werden beispielsweise aus Kupfer mit einer Dicke zwischen 150 µm und 750 µm hergestellt und sind derartig strukturiert, dass beispielsweise metallische Leiterbahnen auf dem dielektrischen Material 12 ausgebildet sind. Die weitere Ausgestaltung des Leistungsmoduls 2 in FIG 2 entspricht der Ausgestaltung in FIG 1.

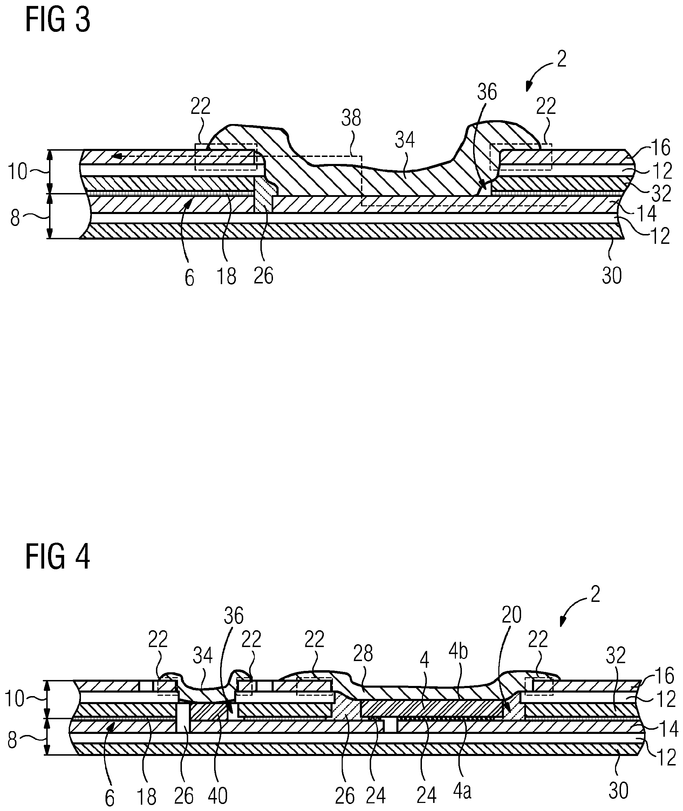

FIG 3 zeigt einen Querschnitt eines Leistungsmoduls 2 im Bereich einer Verbindung zwischen zwei Lagen 8, 10. Die Verbindung, welche einen Teil der ersten Metallisierung 14 mit zumindest einem Teil der zweiten Metallisierung 16 verbindet, wird direkt durch eine als Metallabscheidung ausgeführte zweite Kapselung 34 in einer zweiten Aussparung 36 der zweiten Lage 10 hergestellt und ermöglicht einen Stromfluss 38 von beispielsweise der ersten Metallisierung 14 zur zweiten Metallisierung 16. Teile der zweiten Aussparung 36 sind mit einem Vergussmaterial 26 ausgegossen, um Überkopplungen oder einen Kurzschluss beim Aufbringen der Metallabscheidung zu verhindern. Die weitere Ausgestaltung des Leistungsmoduls 2 in FIG 3 entspricht der Ausgestaltung in FIG 2.

FIG 4 zeigt einen Querschnitt einer vierten Ausführungsform eines Leistungsmoduls 2 im Bereich eines Leistungshalbleiters 4, welcher als Leistungstransistor ausgeführt ist. Ein Teil der ersten Metallisierung 14, welche exemplarisch mit dem Gate des Leistungstransistors elektrisch leitend verbunden ist, wird über ein metallisches Formteil 40 und eine zweite Kapselung 34 mit einem Teil der zweiten Metallisierung 16 elektrisch leitend verbunden. Das metallische Formteil 40 ist als Ronde ausgeführt und wird insbesondere aus Kupfer oder einem Sinterwerkstoff, insbesondere Sinterpaste, hergestellt.

Die Ronde ist in einer zweiten Aussparung 36 der zweiten Lage 10 angeordnet, wobei die zweite Aussparung 36 an die zylindrische Geometrie der Ronde angepasst ist. Ein Mindestabstand zwischen den Metallisierungen 16, 32 der zweiten Lage 10 ist erforderlich, um Überkopplungen zu vermeiden. Die zweite Aussparung 36 ist mit dem elektrisch isolierenden Vergussmaterial 26 der ersten Aussparung 20 ausgegossen, um einen Kurzschluss und/oder ein Überkoppeln zu verhindern. Das Vergussmaterial 26 in der zweiten Aussparung 36 verläuft oberhalb der ersten Metallisierung 14 und maximal bis zur Oberkante der Ronde. Die Ronde ist mit der zweiten Kapselung 34 verbunden, wobei die zweite Aussparung 36 durch die zweite Kapselung 34 fluiddicht verschlossen ist. Die weitere Ausgestaltung des Leistungsmoduls 2 in FIG 4 entspricht der Ausgestaltung in FIG 2.

FIG 5 zeigt verschiedene Verfahrensschritte a) bis f) zur Herstellung eines Leistungsmoduls 2. Im Verfahrensschritt a) wird eine erste Lage 8 eines Substrats 6 bereitgestellt, welches ein dielektrisches Material 12 mit einer beidseitigen Metallisierung 14, 30 aufweist, wobei zumindest eine erste Metallisierung 14 zur Bestückung mit Bauelementen und deren Leitungsführung strukturiert ist. Das Substrat 6 ist als DCB-Substrat ausgeführt, wobei die erste Lage 8 des Substrats 6 zur Vereinfachung der Leitungsführung alternativ mehrlagig ausgeführt ist.

Im darauf folgenden Verfahrensschritt b) wird das Substrat 6 mit Leistungshalbleitern 4 bestückt, welche mit der ersten Metallisierung 14 stoffschlüssig verbunden werden. Insbesondere werden die Leistungshalbleiter 4 durch Löten und/oder Sintern mit der ersten Metallisierung 14 verbunden.

Daraufhin werden im Verfahrensschritt c) als Ronde ausgeführte zylindrische metallische Formteile 40 bestückt, indem sie mit der ersten Metallisierung 14, beispielsweise durch Löten und/oder Sintern, stoffschlüssig verbunden werden. Alternativ wird ein Sinterwerkstoff, insbesondere eine Sinterpaste, bereits im Verfahrensschritt b) mit appliziert werden. Ein insbesondere erhöht gedrucktes Sinterwerkstoff-Depot ersetzt in diesem Fall das metallische Formteil 40. Die Verfahrensschritte b) und c) können in ihrer zeitlichen Reihenfolge vertauscht werden oder gleichzeitig stattfinden.

Im Verfahrensschritt d) wird eine zweite Lage 10 des Substrats 8 bereitgestellt. Die zweite Lage 10 umfasst mehrere Platten des dielektrischen Materials 12 mit einer zweiten Metallisierung 16 und einer vierten Metallisierung 32. Alternativ wird eine große zusammenhängende Platte verwendet. Die zweite Lage 10 weist darüber hinaus Aussparungen 20, 36 auf.

Daraufhin wird die zweite Lage 10 im Verfahrensschritt e) stoffschlüssig, beispielsweise durch Löten und/oder Sintern, mit der ersten Lage 8 verbunden, sodass die Leistungshalbleiter 4 und die zylindrischen metallischen Formteile 40 innerhalb der jeweiligen Aussparungen 20, 36 angeordnet sind. Die Aussparungen 20, 36 der zweiten Lage 10 weisen jeweils eine umlaufende Metallisierung 22 auf, mit welcher eine Kapselung 28, 34 elektrisch leitfähig und fluiddicht verbindbar ist. Die Verfahrensschritte d) und e) sind alternativ vor einem der Verfahrensschritte b) oder c) ausführbar. Die Leistungshalbleiter 4 und/oder die metallischen Formteile 40 würden dann in den Aussparungen 20, 36 bestückt und mit der ersten Metallisierung 14 verbunden werden.

Im Verfahrensschritt f) wird eine Schablone 42, welche beispielsweise aus einem Kunststoff hergestellt ist, auf die zweite Lage 10 des Substrats 6 aufgelegt, welche die Aussparungen 20, 36 mit den Leistungshalbleitern 4 und den zylindrischen metallischen Formteilen 40 sowie die umlaufenden Metallisierungen 22 ausspart. Die Schablone 42 bietet den Vorteil einer präzisen und dabei schnellen Fertigung. Daraufhin werden die Aussparungen 20, 36, wie in FIG 1 zu sehen, mit einem Vergussmaterial 26 ausgegossen. Anschließend werden Kapselungen 28, 34, welche in FIG 5 aus Gründen der Übersichtlichkeit nicht dargestellt sind, aufgebracht, sodass die Leistungshalbleiter 4 und die Formteile 40 über die Kapselungen 28, 34 mit der jeweiligen umlaufenden Metallisierung 22 elektrisch leitend verbunden und die Aussparungen 20, 36 fluiddicht verschlossen sind. Die Kapselungen 28, 34 werden über additive Metallabscheidung direkt lokal aufgebracht, wobei die Schablone 42 dafür sorgt, dass das Metall nur im Bereich der Aussparungen 20, 36 mit der zweiten Metallisierung 16 verbunden wird. Alternativ wird eine Metallabscheidung an einer Begrenzungskante der jeweiligen Lagen 8, 10 vorgenommen. Dies ist in der Praxis allerdings schwieriger, da an einer Begrenzungskante eine Maskierung über eine Schablone 42 eine dreidimensional ausgeführte Schablone 42, welche in einer Dicke profiliert ist, erfordert. Über die Aussparungen 20, 36 und die umlaufenden Metallisierungen 22 sind alle Bereiche mit einer zweidimensionalen Schablone optimal abdeckbar, was die Herstellungskosten wegen der geringen Schablonenstandzeit senkt. Die weitere Ausführung des Leistungsmoduls 2 in FIG 5 entspricht der Ausführung in FIG 4.

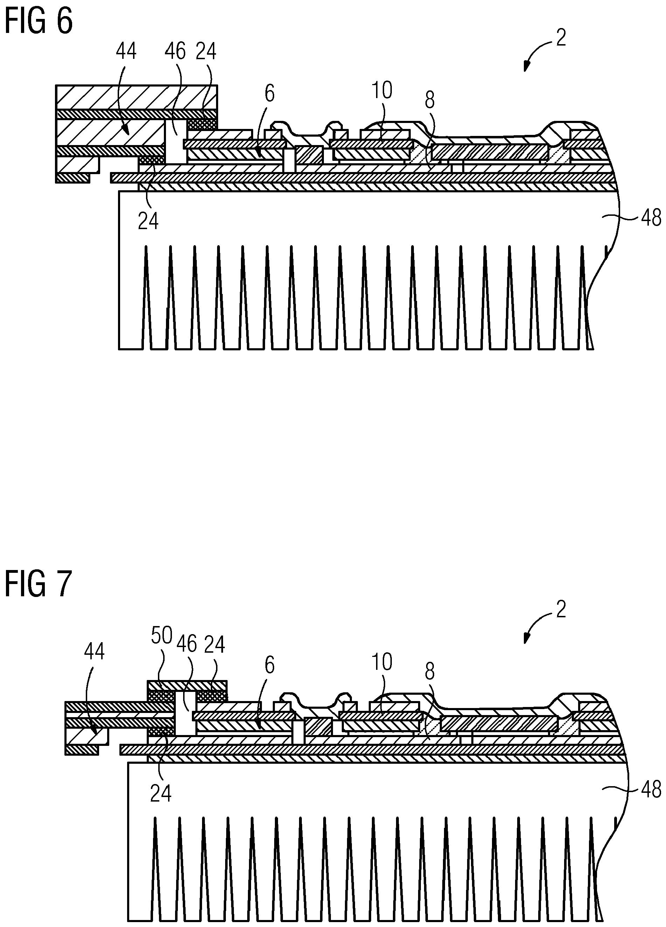

FIG 6 zeigt einen Querschnitt der vierten Ausführungsform des Leistungsmoduls 2 mit einer ersten Ausführungsform einer Kontaktierung an eine Leiterplatte 44. Die Lagen 8, 10 des Substrats 6 sind gestuft angeordnet. Die mehrlagige Leiterplatte 44 ist im Bereich der Kontaktierung mit dem Substrat 6 ebenfalls gestuft und korrespondierend zum Substrat 6 ausgeführt, sodass die Leiterplatte 44 mit einer, insbesondere stoffschlüssigen, Verbindung 24, beispielsweise einer Lötverbindung oder Sinterverbindung, mit dem Substrat 6 verbunden ist. Zwischen den Verbindungen 24 der ersten Lage 8 und der zweiten Lage 10 mit der Leiterplatte 44 befindet sich ein, insbesondere mit Luft durchströmter, Abstand 46, um ein Überkoppeln zu verhindern. Der Abstand 46 ist alternativ zumindest teilweise mit einem dielektrischen Werkstoff mit guten Isolationseigenschaften gefüllt.

Das Substrat 6 des Leistungsmoduls 2 ist über die erste Lage 8, insbesondere vollflächig, thermisch leitend mit einem Kühlkörper 48 verbunden, welcher insbesondere aus Aluminium und/oder Kupfer hergestellt ist und optional Kühlkanäle aufweist, in welchen ein Kühlfluid zirkuliert. Die weitere Ausführung des Leistungsmoduls 2 in FIG 6 entspricht der Ausführung in FIG 4.

FIG 7 zeigt einen Querschnitt der vierten Ausführungsform des Leistungsmoduls 2 mit einer zweiten Ausführungsform einer Kontaktierung an eine Leiterplatte 44. Das Substrat 6 weist, wie in FIG 6 exemplarisch zwei Lagen 8, 10 auf, die zur Leiterplatte 44 hin gestuft angeordnet sind, wobei die mehrlagige Leiterplatte 44, welche ebenfalls gestuft ausgeführt ist, über eine Metallisierung direkt, insbesondere über eine stoffschlüssige Verbindung 24, mit der ersten Lage 8 des Substrats 6 verbunden ist. Die zweite Lage 10 des Substrats 6 ist über eine Brücke 50, welche insbesondere mindestens ein gerades rechteckiges Metallblech umfasst, mit einer weiteren Metallisierung der Leiterplatte 44 verbunden. Die weitere Ausführung des Leistungsmoduls 2 in FIG 7 entspricht der Ausführung in FIG 6.

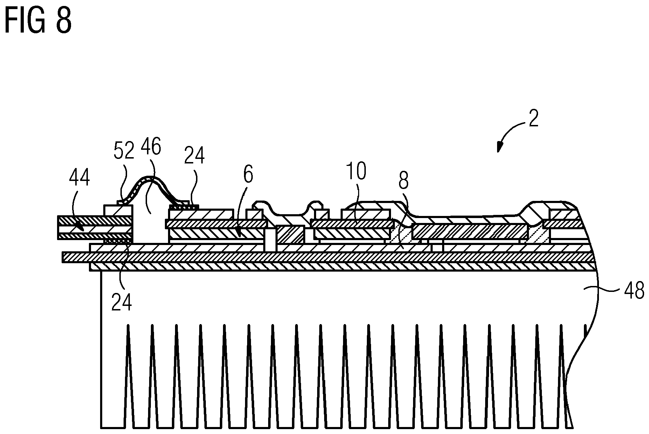

FIG 8 zeigt einen Querschnitt der vierten Ausführungsform des Leistungsmoduls 2 mit einer dritten Ausführungsform einer Kontaktierung an eine Leiterplatte 44. Die Leiterplatte 44 ist über eine Metallisierung direkt mit der ersten Lage 8 des Substrats 6 verbunden. Die zweite Lage 10 des Substrats 6 ist über eine Bondverbindung 52 mit einer weiteren Metallisierung der Leiterplatte 44 verbunden. Die Bondverbindung 52 umfasst mindestens einen Bonddraht, welcher einen runden oder einen rechteckigen Querschnitt aufweist und optional als Band ausgebildet ist. Der mindestens eine Bonddraht 52 wird beispielsweise aus Kupfer, Gold oder Silber hergestellt. Das Bonden erfolgt beispielsweise durch Ultraschallschweißen. Alternativ wird der Bonddraht festgelötet. Die weitere Ausführung des Leistungsmoduls 2 in FIG 8 entspricht der Ausführung in FIG 7.

Zusammenfassend betrifft die Erfindung ein Leistungsmodul 2 mit mindestens einem Leistungshalbleiter 4, insbesondere einem Leistungstransistor, welcher eine erste Kontaktfläche 4a und eine der ersten Kontaktfläche 4a gegenüberliegende zweite Kontaktfläche 4b aufweist, und einem Substrat 6, welches zumindest zwei übereinander angeordnete miteinander verbundene Lagen 8, 10 umfasst. Um eine, im Vergleich zum Stand der Technik, höhere Beständigkeit gegenüber Feuchtigkeit zu erreichen und eine niederinduktive planare Anbindung des mindestens einen Leistungshalbleiters 4 zu ermöglichen, wird vorgeschlagen, dass die erste Lage 8 ein erstes dielektrisches Material 12 mit zumindest einer ersten Metallisierung 14 umfasst, wobei die erste Metallisierung 14 auf einer der zweiten Lage 10 zugewandten Seite angeordnet ist, wobei die zweite Lage 10 ein zweites dielektrisches Material 12 mit zumindest einer zweiten Metallisierung 16 umfasst, wobei die zweite Metallisierung 16 auf einer der ersten Metallisierung 14 abgewandten Seite angeordnet ist, wobei der Leistungshalbleiter 4 über die erste Kontaktfläche 4a mit der ersten Metallisierung 14 verbunden ist, wobei der Leistungshalbleiter 4 in einer ersten Aussparung 20 der zweiten Lage 10 angeordnet ist, wobei eine metallische erste Kapselung 28 derartig angeordnet ist, dass der Leistungshalbleiter 4 fluiddicht gekapselt ist und die zweite Kontaktfläche 4b des Leistungshalbleiters 4 über die erste Kapselung 28 elektrisch leitend mit der zweiten Metallisierung 16 verbunden ist.

## Patentansprüche

1. Leistungsmodul (2) mit mindestens einem Leistungshalbleiter (4), insbesondere einem Leistungstransistor,
welcher eine erste Kontaktfläche (4a) und eine der ersten Kontaktfläche (4a) gegenüberliegende zweite Kontaktfläche (4b) aufweist, und
einem Substrat (6), welches zumindest zwei übereinander angeordnete miteinander verbundene Lagen (8, 10) umfasst,
wobei die erste Lage (8) ein erstes dielektrisches Material (12) mit zumindest einer ersten Metallisierung (14) umfasst, wobei die erste Metallisierung (14) auf einer der der zweiten Lage (10) zugewandten Seite angeordnet ist,
wobei die zweite Lage (10) ein zweites dielektrisches Material (12) mit zumindest einer zweiten Metallisierung (16) umfasst,
wobei die zweite Metallisierung (16) auf einer der ersten Metallisierung (14) abgewandten Seite angeordnet ist,
wobei der Leistungshalbleiter (4) über die erste Kontaktfläche (4a) mit der ersten Metallisierung (14) verbunden ist, wobei der Leistungshalbleiter (4) in einer ersten Aussparung (20) der zweiten Lage (10) angeordnet ist,
wobei eine metallische erste Kapselung (28) derartig angeordnet ist, dass
- der Leistungshalbleiter (4) fluiddicht gekapselt ist und
- die zweite Kontaktfläche (4b) des Leistungshalbleiters (4) über die erste Kapselung (28) elektrisch leitend mit der zweiten Metallisierung (16) verbunden ist.

2. Leistungsmodul (2) nach Anspruch 1,
wobei die erste Kapselung (28) über ein additives Fertigungsverfahren hergestellt ist.

3. Leistungsmodul (2) nach einem der Ansprüche 1 oder 2,
wobei in der ersten Aussparung (20) ein elektrisch isolierendes Vergussmaterial (26) angeordnet ist.

4. Leistungsmodul (2) nach einem der vorherigen Ansprüche,
wobei die erste Lage (8) eine dritte Metallisierung (30) umfasst, welche auf einer der ersten Metallisierung (14) gegenüberliegenden Seite angeordnet ist und/oder
wobei die zweite Lage (10) eine vierte Metallisierung (32) umfasst, welche auf einer der zweiten Metallisierung (16) gegenüberliegenden Seite angeordnet ist.

5. Leistungsmodul (2) nach einem der vorherigen Ansprüche,
wobei die erste Kapselung (28) stoffschlüssig mit der zweiten Kontaktfläche (4b) des Leistungshalbleiters (4) verbunden ist.

6. Leistungsmodul (2) nach einem der vorherigen Ansprüche, wobei die zweite Metallisierung (16) eine umlaufende Metallisierung (22) aufweist, welche um die erste Aussparung (20) der zweiten Lage (12) angeordnet ist,
wobei die erste Kapselung (28) fluiddicht mit der umlaufenden Metallisierung (22) verbunden ist.

7. Leistungsmodul nach Anspruch 6,
wobei sich die erste Kapselung (28) zumindest über die erste Aussparung (20) und zumindest über einen Teil der umlaufenden Metallisierung (22) erstreckt.

8. Leistungsmodul nach einem der vorherigen Ansprüche,
wobei zumindest ein Teil der ersten Metallisierung (14) über eine zweite Kapselung (34) mit zumindest einem Teil der zweiten Metallisierung (16) elektrisch leitend verbunden ist.

9. Leistungsmodul nach Anspruch 8,
wobei in der zweiten Aussparung (36) ein elektrisch isolierendes Vergussmaterial (26) angeordnet ist und wobei die zweite Aussparung (36) durch die zweite Kapselung (34) fluiddicht verschlossen ist.

10. Leistungsmodul nach einem der Ansprüche 8 oder 9,
wobei die zweite Kapselung (34) über ein, insbesondere als Ronde ausgeführtes, metallisches Formteil (40) mit der ersten Metallisierung verbunden (14) ist.

11. Leistungsmodul nach einem der Ansprüche 8 bis 10,
wobei die zweite Kapselung (34) über ein additives Fertigungsverfahren hergestellt ist.

12. Verfahren zur Herstellung eines Leistungsmoduls (2) nach einem der Ansprüche 1 bis 11,
wobei die erste Kontaktfläche (4a) des Leistungshalbleiters (4) elektrisch leitend mit der ersten Metallisierung (14) der ersten Lage (8) verbunden wird,
daraufhin die zweite Lage (10), welche eine erste Aussparung (20) um den Leistungshalbleiter (4) herum aufweist, mit der ersten Lage (8) verbunden wird,
daraufhin eine metallische erste Kapselung (28) derartig angeordnet wird, dass der Leistungshalbleiter (4) fluiddicht gekapselt wird und die zweite Kontaktfläche (4b) des Leistungshalbleiters (4) über die erste Kapselung (28) elektrisch leitend mit der zweiten Metallisierung (16) verbunden wird.

13. Verfahren nach Anspruch 12,
wobei die zweite Lage (10) eine vierte Metallisierung (32) umfasst, welche auf einer der zweiten Metallisierung (16) gegenüberliegenden Seite angeordnet ist,
wobei die erste Aussparung (20) derartig mit einem elektrisch isolierenden Vergussmaterial (28) ausgegossen wird, dass das Vergussmaterial (26) über die vierte Metallisierung (32) hinausragt und maximal bis zur zweiten Kontaktfläche (4b) des Leistungshalbleiters (4) angeordnet ist.

14. Verfahren nach einem der Ansprüche 12 oder 13,
wobei zumindest ein Teil der ersten Metallisierung (14) über eine zweite Kapselung (34) mit zumindest einem Teil der zweiten Metallisierung (16) elektrisch leitend verbunden wird, wobei die zweite Aussparung (36) durch die zweite Kapselung (34) fluiddicht verschlossen wird.

15. Verfahren nach einem der Ansprüche 12 bis 14,
wobei die erste Kapselung (28) und/oder die zweite Kapselung (34) über ein additives Fertigungsverfahren, insbesondere mit einer Schablone (42), aufgebracht werden.
